(19) Europäisches Patentamt
European Patent Office
Office européen des brevets

(11) EP 2 726 644 B1

(12) FASCICULE DE BREVET EUROPEEN

(45) Date de publication et mention de la délivrance du brevet:
**01.07.2015 Bulletin 2015/27**

(21) Numéro de dépôt: **12733642.8**

(22) Date de dépôt: **28.06.2012**

(51) Int Cl.:
***C23C 16/455*** (2006.01) ***C23C 16/442*** (2006.01)
***G21C 3/20*** (2006.01) ***G21C 3/62*** (2006.01)
***G21C 21/02*** (2006.01) ***C23C 16/44*** (2006.01)

(86) Numéro de dépôt international:
**PCT/EP2012/062609**

(87) Numéro de publication internationale:
**WO 2013/001024 (03.01.2013 Gazette 2013/01)**

# (54) REACTEUR DE TYPE LIT A JET A PROFILE SPECIFIQUE

WIRBELBETTREAKTOR MIT BESONDEREM PROFIL

FLUIDIZED BED REACTOR WITH SPECIFIC SHAPE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.06.2011 FR 1155760**

(43) Date de publication de la demande:
**07.05.2014 Bulletin 2014/19**

(73) Titulaire: **Commissariat à l'Énergie Atomique et aux Énergies Alternatives
75015 Paris (FR)**

(72) Inventeurs:
- **BROTHIER, Méryl
F-13090 Aix en Provence (FR)**
- **MOULINIER, Dominique
F-04860 Pierrevert (FR)**
- **RODRIGUEZ, Philippe
F-38140 Rives (FR)**
- **ABLITZER, Carine
F-83560 Saint-Julien Le Montagnier (FR)**

(74) Mandataire: **Ahner, Philippe et al
BREVALEX
95, rue d'Amsterdam
75378 Paris Cedex 8 (FR)**

(56) Documents cités:
**FR-A1- 2 354 611 FR-A1- 2 526 677
JP-A- 56 108 526 JP-A- 56 111 036**

- **GELDART D: "TYPES OF GAS FLUIDIZATION.", POWDER TECHNOLOGY 1973 MAY, vol. 7, no. 5, 1 mai 1973 (1973-05-01), pages 285-292, XP002669531, DOI: DOI:10.1016/0032-5910(73) 80037-3 cité dans la demande**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).



Printed by Jouve, 75001 PARIS (FR)

## Description

## DOMAINE TECHNIQUE ET ART ANTERIEUR

Dans le cadre de procédés mettant en oeuvre un dépôt sur poudres ou particules par techniques de type dite CVD (Dépôt chimique en phase gazeuse), il est parfois nécessaire selon les caractéristiques du matériau granulaire sur lequel l'on souhaite réaliser le dépôt de mettre en oeuvre une fluidisation par lit à jet. Cette mise en oeuvre permet un brassage efficace (et donc un dépôt homogène) du lit de poudre malgré la difficulté de fluidiser cette dernière. La présente invention propose une conception spécifique de réacteur de lit à jet permettant une amélioration de la maîtrise des conditions de dépôt pour des cas induisant une modification significative des caractéristiques du lit du fait même de ce dépôt. C'est typiquement le cas pour des réacteurs de type à lit à jet dédiés à l'élaboration de particules de combustibles utilisables (particules triso) pour des réacteurs de type HTR (Réacteur à haute Température).

On rappelle d'abord que les lits à jet induisent la formation d'une fontaine au-dessus d'un lit de particules. Cette technique est donc très différente de celle du lit fluidisé, qui ne provoque qu'un brassage relativement homogène d'un lit de particules. Les réacteurs de type à lit à jet, d'une part, et les réacteurs de type à lit fluidisé, d'autre part, n'ont donc pas du tout la même hydrodynamique, ne sont pas optimisés de la même façon et l'optimisation de l'un des 2 types ne permet pas l'optimisation de l'autre type.

Les premiers lits à jets ont été décrits par Mathur et Gishler (Mathur, K. B., Gishler, P. E., A.1.Ch.E. J. 1, 157 (1955)).

Les réacteurs à lits fluidisés sont décrits par exemple dans les techniques de l'ingénieur (Calcul des réacteurs à lits fluidisés, J4100, 10 mars 1992 Khalil Shakourzadeh) et l'un des premiers brevets décrivant ce type de réacteur est par exemple le brevet allemand DE 437,970 (1922) de F. Winkler.

La fluidisation de charges granulaires (appelée lit) est un mode très satisfaisant pour mettre en contact un gaz et ces charges dans le cadre de procédés industriels dans des applications très multiples (séchage, enrobage, réaction catalytique,...).

Ce phénomène de fluidisation n'est cependant pas aisé pour tout type de particules, comme l'a montré Geldart dans sa classification des poudres (Geldart D. (1973), Powder Technology. Vol. 7, p 285).

Le graphique de la figure 8 résume cette classification : on trouve, en ordonnée, la différence de masse volumique entre le gaz de fluidisation et la poudre à fluidiser et, en abscisse, le diamètre moyen de la poudre considérée.

On distingue sur ce graphique les poudres :

- de la zone A, qui correspond aux poudres relativement bien fluidisables, i.e. avec une fluidisation homogène (sans grosse bulle dans le lit fluidisé),
- de la zone B, qui est celle des poudres pleinement fluidisables,
- de la zone C, qui correspond aux poudres cohésives, très difficilement fluidisables : ces poudres ne rentrent pas en mouvement d'une manière homogène dans le lit, ce qui se traduit par des variations importantes de la perte de charge, dans le lit, pour des débits néanmoins très proches ou équivalents, selon les essais de fluidisation,
- de la zone D, qui est celle des poudres relativement denses, fluidisables dans les conditions privilégiées de lit à jet.

Pour les particules dites de type D (particules de gros diamètres et de grosses densités) dans cette classification, la fluidisation est classiquement mise en oeuvre par le biais d'un réacteur de type lit à jet. Dans ce type de lit, le gaz permettant la fluidisation de la charge est introduit en partie basse, induisant un mouvement périodique et la formation d'une fontaine, d'où le nom de lit à jet.

On connait différents types de lits.

On connait les lits à jet à profil à angle droit, réalisation la plus simple qui soit, car l'injection de gaz est assurée par un injecteur au droit d'une section cylindrique. Ce type de profil, représentée schématiquement, en figure 1A, n'est pas optimisé du point de vue de la fluidisation de la charge granulaire, puisqu'il induit d'importants volumes morts, c'est-à-dire des zones 1, 1' dans lesquelles les temps de passage des particules sont très longs, comparativement à la moyenne des autres zones du lit. En ce sens, ce type de configuration à angle droit n'est quasiment pas utilisé industriellement.

Les lits à jet à profil conique, du type représenté schématiquement en figure 1B, sont classiquement utilisés pour la mise en oeuvre de poudres difficilement fluidisables, au sens de Geldart. De nombreux exemples en sont donnés dans l'art antérieur, par exemple dans les documents CA 601607, US 4342284, GB 1567256. Ce type de lit à jet répond bien au besoin pour les procédés de dépôt, dans la mesure où les caractéristiques de ces charges (diamètre et masse volumique apparente des particules principalement), du fait même de ce dépôt, ne sont pas significativement modifiées.

Mais, dans le cas où l'on est contraint de mettre en oeuvre une masse réduite de charge (cas de matière onéreuse ou pouvant induire un risque de criticité, par exemple) des effets de bords importants se manifestent. En effet, il n'est alors pas envisageable de réduire d'une façon inconsidérée le diamètre du réacteur, car les effets de bords (influences de la paroi sur l'écoulement de la poudre) ne sont pas négligeables jusqu'à une distance à la paroi sensiblement inférieure ou égale à au moins 10 fois le diamètre des particules à fluidiser. L'on ne peut donc pas réduire le diamètre de réacteur trop fortement sans perturber une forte proportion de l'écoulement des poudres. Ce type de lit n'est donc pas optimisé, puisque l'essentiel de la charge, lorsqu'elle est réduite, se trouve alors dans la partie conique 2, de volume $V_o$, entre les cotes $Z_0$ et $Z_1$ de la figure 1B (entre l'orifice de sortie du conduit 18 d'injection des gaz et la partie inférieure de la portion cylindrique 12), ce qui rend les conditions, en cours de dépôt, peu stables ; en particulier, la vitesse d'écoulement du gaz à travers les particules est non constante au cours du dépôt, du fait du changement de section de passage.

Les lits à jet à profil concave, dont un exemple représente schématiquement en figure 1C, sont utilisés pour des charges généralement importantes. Plusieurs exemples industriels sont à noter comme décrit dans le document EP 1752991. Pour le cas d'une limitation forcée de la quantité de matière, ce type de profil est encore plus défavorable, puisqu'il maximise le volume $V_o$, pour une hauteur donnée de transition ($Z_1$-$Z_0$), défini comme ci-dessus, entre l'orifice de sortie du conduit 18 d'injection des gaz et la partie inférieure de la portion cylindrique 12.

Dans certains cas, on complexifie les profils de lits à jets classiques décrits ci-dessus. Ainsi, il est notamment possible de mettre en oeuvre des éléments mobiles pour aider la fluidisation (cas des documents EP 1 550 502 ou CN 10 183 06 27 par exemple) ou de disposer en série des lits (comme dans US 2009/0149620). Les modes d'injections du gaz de fluidisation peuvent également être modifiés pour favoriser la fluidisation (comme décrit dans RU2377487). Ces dispositifs sont optimisés pour un mode d'application spécifique, mais peu adaptés pour le cas d'une mise en oeuvre de matière, telle qu'une matière nucléaire, n'autorisant pas les interventions/maintenances fréquentes lors de la mise en oeuvre de solutions aussi sophistiquées et moins robustes que les profils simplifiés décrits précédemment.

Par ailleurs, comme pour les cas décrits plus haut, ces profils ne permettent pas de minimiser le volume Vo, critère pertinent notamment dans le cas d'une mise en oeuvre de quantité de matière limitée, comme déjà évoqué précédemment.

Il se pose donc le problème de pouvoir réaliser un/des dépôts, en particulier par technique CVD, sur une charge difficilement fluidisable, notamment au sens donné par Geldart, induisant également un fort risque de colmatage et/ou de bouchage, notamment au droit de l'injection de gaz (c'est-à-dire à la cote $Z_0$).

On peut également considérer une poudre comme difficilement fluidisable si la vitesse minimale de gaz, nécessaire à cette fluidisation, est très importante et que le phénomène est peu reproductible ou du moins très sensible à de légères variations thermohydrauliques ou de caractéristiques des poudres ; l'on parle également de fluidisation peu aisée lorsque la perte de charge induite par un écoulement gazeux au travers du lit à fluidiser est fluctuant, malgré une légère augmentation de la vitesse de circulation du gaz au travers du lit de poudre à fluidiser.

A titre d'exemple, c'est le cas pour la fabrication de particules dites TRISO (i.e à trois couche) rentrant dans la composition de combustibles nucléaires pour les réacteurs dits HTR (« Réacteur à haute Température »). La masse en uranium manipulable pour permettre une mise en oeuvre aisée de la charge (i.e. sans risque de criticité) est alors souvent limitée à 350 ou 600 g d'uranium 235 (suivant les marges imposées par les règles de sûreté et selon l'enrichissement isotopique de l'uranium mis en oeuvre). On cherche alors à réaliser des dépôts multiples dans le même réacteur CVD, ce qui entraine, lors de chaque phase successive de dépôt, une modification du diamètre et de la densité apparente des particules à fluidiser (le diamètre est typiquement doublé lors de ce type de dépôt et les densités, au contraire, peuvent être divisées par un facteur 3). Dans ce cas, cette variation importante des caractéristiques de la charge en cours de dépôt (et du fait même de ce dernier) peut être très pénalisante car les conditions de fluidisation de la charges vont être, de fait, modifiées. Cela est d'autant plus significatif que le dépôt a lieu dans le volume de transition appelé $V_o$ tel que défini ci-dessus.

3 contraintes sont en outre à prendre en compte :

- la première tient au fait que la charge sur laquelle doit être réalisé le dépôt est supposée, de par ce dépôt, varier significativement en terme de densité apparente et de granulométrie,
- la deuxième réside dans le fait que la charge sur laquelle doit s'effectuer le dépôt est nécessairement de masse limitée, du fait que cette charge est, par exemple, très onéreuse et/ou sujette à induire un risque de criticité,
- la troisième réside dans le souhait de limiter les risques de bouchage à l'interface lit/débouchant injecteur gaz.

On cherche donc un profil spécifique de réacteur permettant, de préférence tout à la fois, de :

- limiter le volume de transition Vo (volume du lit situé entre les cotes $Z_0$ et $Z_1$ sur les schémas des figures 1B et 1C),
- et/ou minimiser les zones dites mortes du lit et de la phase gazeuse utilisée pour le dépôt,
- et/ou limiter les pertes de charges en garantissant une fluidisation suffisante au niveau de la charge.

Il n'existe aucune structure connue de lit à jet qui réponde à cette problématique complexe.

La présente invention se propose ainsi de résoudre le problème posé.

Il se pose notamment avec beaucoup d'acuité dans le cas de la fabrication de particules de combustibles multicouches utilisés dans les réacteurs nucléaires de type HTR.

## EXPOSÉ DE L'INVENTION

On décrit ici un réacteur à lit à jet (ou « spouted bed » en terminologie anglaise), comportant une zone cylindrique, un unique conduit d'injection de gaz à la base de la zone cylindrique, et une zone de transition, reliant l'extrémité supérieure du conduit à la base de la zone cylindrique, cette zone de transition ayant un profil majoritairement convexe dans un plan passant par l'axe d'écoulement d'un fluide dans le conduit.

Le profil peut avoir des zones de convexité et des zones de non-convexité ; mais les zones de non-convexité sont majoritaires, c'est à dire que leurs aires (ou volumes si on parle en 3D) telles que définies, comparativement à l'évidement d'un profil droit conique sont supérieures à celles des zones convexes.

On décrit donc un nouveau profil de transition entre la section d'injection du gaz du lit à jet et la section terminale (ou inférieure) cylindrique du réacteur, qui permet de minimiser le volume de solide à fluidiser qui n'est pas compris dans la section cylindrique (volume Vo). Ceci permet de rendre le lit de poudre à revêtir moins sensible, pendant le dépôt, aux changements de densité $\rho$ et de granulométrie d et conduit à une meilleure maîtrise du dépôt durant l'ensemble du processus.

Comme déjà expliqué ci-dessus, l'évolution de ces paramètres de densité $\rho$ et de granulométrie d entraîne une évolution des conditions de dépôt et, donc, des réglages des conditions de mise en oeuvre du procédé, sauf si l'on est capable d'accompagner cette évolution pour piloter en direct le dépôt, ce qui est très délicat et conduit à des instabilités de comportement du lit. Mais les conditions thermohydrauliques ne sont pas constantes et parfois chaotiques et il est préférable d'avoir un profil de réacteur de lit à jet qui lisse au mieux ces fluctuations. Le mieux est alors de travailler dans la zone cylindrique (i.e. au dessus de Vo) puisqu'il s'agit de la forme la plus optimisée, i.e. la moins sensible à l'évolution des diamètres des particules et de leurs densités apparentes vis-à-vis des conditions de dépôt.

Le type de profil proposé dans la présente demande permet une transition rapide, mais efficace, et notamment sans création de volume mort, entre la section d'injection de gaz, permettant la fluidisation par jet, et la section cylindrique du réacteur de dépôt.

Par ailleurs, ce type de profil permet une minimisation des risques de bouchage (ou les risques de collage particule/paroi/injecteur) au droit de l'injecteur de gaz du lit à jet.

En effet, dans le cas d'un lit convexe, la section du passage, juste après la sortie du conduit d'injection de gaz, est plus restreinte que dans le cas d'un profil concave ou plat.

Il en résulte que la vitesse de gaz, en sortie du conduit d'injection de gaz, est plus importante dans le cas d'un lit à profil convexe que dans le cas d'un lit à profil concave ou conique. Ainsi, pour un même débit de gaz injecté, la vitesse d'écoulement du gaz ainsi que la vitesse des particules au droit de l'injecteur de gaz seront plus importantes avec un profil convexe. Dans le cas de l'exemple des particules dites TRISO, le gaz injecté contient notamment le précurseur de carbone à déposer sur les particules.

L'angle $\beta$ entre l'axe (YY') d'écoulement d'un fluide dans le conduit et la tangente au profil convexe, au point où celui-ci rejoint le conduit est de préférence au moins égal à 5°, et, de préférence, inférieur à 45°, et encore plus préférentiellement, compris entre 10° et 35°.

Le profil convexe peut présenter un point d'inflexion ; dans ce cas, on réalise un angle $\theta_1$ entre, d'une part, un axe perpendiculaire à la direction d'écoulement d'un fluide et passant par la base de la partie cylindrique et, d'autre part, la tangente au point d'inflexion I du profil convexe, préférentiellement supérieur à 10° et/ou supérieur à l'angle d'écoulement spontané de la poudre constitutive du lit à fluidiser sur plan incliné.

De préférence l'angle $\theta_2$ entre, d'une part, un axe perpendiculaire à la direction d'écoulement d'un fluide et passant par la base de la partie cylindrique et, d'autre part, une droite passant par l'extrémité du conduit d'injection de gaz et par la base de la partie cylindrique, est inférieur à 90° et/ou supérieur à l'angle d'écoulement spontané de la poudre constitutive du lit à fluidiser sur plan incliné.

On choisira de préférence une distance, entre l'extrémité du conduit d'injection des gaz et la base de la section cylindrique du réacteur, supérieure à 1/10 du rayon du lit dans cette section cylindrique.

Le profil convexe peut en outre être défini par une succession de N ($N \geq 2$) segments de droite (dn) dont aucun n'est vertical.

Un procédé de fluidisation de particules d'un lit de particules peut comporter la mise en oeuvre d'un réacteur à lit à jet tel que ci dessus. Avantageusement, les particules, ou au moins une partie d'entre elles, ont un diamètre supérieur ou égal à 100 $\mu$m ou à 500 $\mu$m, ou voisin de l'une de ces valeurs, et/ou la différence de masse volumique entre le gaz de fluidisation et la poudre à fluidiser étant supérieure ou égale à 0,1 g/cm$^3$ ou à 0,5 g/cm$^3$ ou à 1 g/cm$^3$ ou à 5 g/cm$^3$.

On peut notamment réaliser une pluralité de dépôts successifs sur lesdites particules, par exemple avec un gaz d'une première nature, puis un gaz d'une deuxième nature, différente de la première.

Par exemple, les particules comportent des particules de combustibles multicouches utilisés dans les réacteurs nucléaires de type HTR.

## BRÈVE DESCRIPTION DES DESSINS

On décrira à présent, à titre d'exemples non limitatifs, des modes de réalisation de l'invention, en se référant aux dessins annexés, dans lesquels :

- les figures 1A - 1C sont des vues schématiques, en coupe transversale, de systèmes connus,
- la figure 2A est une vue schématique en coupe transversale, d'un lit à jet avec un nouveau profil, selon l'invention, comportant dans cet exemple un point d'inflexion, pour la section d'injection du gaz d'un lit à jet et la section terminale cylindrique d'un réacteur,
- la figure 2B est une vue schématique en coupe transversale, d'une variante d'un lit à jet avec un nouveau profil, selon l'invention, comportant une zone de convexité et une zone de non-convexité,
- la figure 3 est une vue détaillée, en coupe transversale, d'un lit à jet avec un nouveau profil pour la section d'injection du gaz d'un lit à jet et la section terminale cylindrique d'un réacteur,
- les figures 4A et 4B sont des comparaisons, pour une même charge granulaire (en termes de masse et de caractéristiques physique), de l'évolution de la perte de charge à travers un lit à profil linéaire connu (figure 4A) et un lit avec une section d'injection à profil convexe avec un angle $\beta$ =0 (figure 4B),
- la figure 4C représente l'évolution de la perte de charge à travers un lit avec une section d'injection à profil convexe, pour une valeur d'angle $\beta$ = 10°,
- la figure 5 représente une section d'injection à profil convexe, approchée par un ensemble de segments de droites,
- la figure 6 représente des exemples de profils d'une section d'injection à profil convexe,
- les figures 7A et 7B sont des exemples de réalisation d'une section d'injection à profil convexe,
- la figure 8 représente schématiquement une classification connue des poudres.

## EXPOSÉ DÉTAILLÉ DE MODES DE RÉALISATION PARTICULIERS

Un exemple d'un nouveau profil de section d'injection est décrit en liaison avec la figure 2A.

On reconnaît schématiquement sur cette figure la structure d'une partie 12, à section cylindrique, d'un lit fluidisé et de la zone 14 d'injection dans cette partie cylindrique.

Comme on le voit sur cette figure, cette zone 14 d'injection n'a pas un profil à angle droit, ou conique, concave, comme décrit ci-dessus en liaison avec les figures 1A - 1C. Des exemples de dimensionnement, et notamment de la hauteur $h_1$ et du diamètre intérieur $d_2$ (= $2xr_2$) de la section cylindrique 12 sont donnés plus loin. Plus généralement :

la hauteur $h_1$ est, de préférence, supérieure au dixième du rayon $r_2$
- et/ou inférieure à 5 fois $d_2$.

Les représentations des figures 2A et 2B doivent être comprises comme étant à symétrie de révolution autour de l'axe vertical YY', qui se confond avec l'axe du conduit 18 d'alimentation en gaz.

La zone 14 d'injection a, dans un plan contenant l'axe YY', un profil convexe, avec la convexité tournée vers l'extérieur du dispositif. On a représenté, à titre de comparaison, en traits interrompus, un profil 16 conique, qui part de la sortie du conduit 18 d'alimentation en gaz et qui rejoint la base ou l'extrémité inférieure de la partie cylindrique 12. On constate que, pour l'essentiel, le profil convexe 14 se situe « au-dessus » du profil conique 16.

La figure 2B représente une variante de profilé selon l'invention. Sur cette figure, des références identiques à celles de la figure 2A y désignent des éléments identiques ou correspondants. On voit sur cette figure 2B que le profil 14 peut, dans un plan contenant l'axe YY', ne pas être que convexe, mais qu'il peut avoir des zones 14-1 de convexité (la convexité est tournée vers l'extérieur du dispositif) et des zones 14-2 de non-convexité (c'est-à-dire ne présentant pas de convexité tournée vers l'extérieur du dispositif). Les zones de non-convexité sont majoritaires, c'est à dire que la somme des surfaces S1 hachurées (ou volumes si on parle en 3D) comprises entre le profil des zones 14-1 convexes et le profil 16 droit conique (déjà défini ci-dessus) est strictement supérieure à la somme des surfaces S2 hachurées (ou volumes si on parle en 3D) comprises entre le profil des zones 14-2 non convexes et le profil 16 droit conique.

Autrement dit, le volume (hachuré sur la figure), défini entre le plan P qui passe par l'extrémité inférieure de la partie cylindrique 12 et la plan P' qui passe par l'extrémité supérieure du conduit 18 d'alimentation en gaz est, dans le cas du profil convexe, ou majoritairement convexe, inférieur à ce qu'il est dans le cas d'un profil conique, et, par voie de conséquence, à ce qu'il est dans le cas d'un profil à angle droit dans le cas d'un profil concave.

Le nouveau profil proposé permet donc de minimiser le volume de solide à fluidiser qui n'est pas compris dans la section cylindrique (volume $V_0$), tout en permettant une fluidisation efficace. Ceci permet, notamment dans le cas d'une poudre destinée à former un revêtement, de rendre le lit de poudre moins sensible aux changements de densité $\rho$ et de granulométrie d pendant le dépôt et permet ainsi une meilleure maîtrise du dépôt durant l'ensemble du processus.

Des exemples de profils reproduisant la section 14 sont donnés sur la figure 6.

Chacun de ces profils suivent une équation :

$$R_1 = 2.65+0,00533z^2 ;$$

$$R_2 = 2.62+0.176z-3.81x10^{-3}z^2 +9.6x10^{-5}z^3 ;$$

A la différence de ces deux exemples, un profil convexe ne peut pas toujours être mis sous forme d'une équation.

Il est aussi possible de réaliser un profil convexe, ou majoritairement convexe, par une succession de segments de droite, comme illustré sur la figure 5.

Le profil convexe, ou majoritairement convexe, est alors formé par une succession de N (N>1 ou N>2 ou N>5) segments de droite $d_n$ (n= 0, 1, ....N), chaque segment étant compris entre deux extrémités $I_n$, $I_{n+1}$ ; $I_n$ est donc le point d'intersection entre les segments de droites $d_n$ et $d_{n-1}$ avec l'expression suivante de la droite $d_n$ (n étant ≥ 1) :

$$Y(n) = \frac{y_n - y_{n-1}}{x_n - x_{n-1}}.x + y_n - (\frac{y_n - y_{n-1}}{x_n - x_{n-1}}).x_{n-1}$$

avec $y_n$ et $x_n$ les coordonnées du point $I_n$ dans le repère (x,y) tel que défini sur la figure 5, l'axe Y étant confondu avec la projection, dans le plan YX, de la parie latérale du corps cylindrique 12, et l'axe X étant perpendiculaire à l'axe Y et passant par le point B d'intersection entre le cylindre 12 et la portion convexe 14. L'origine $I_0$ se situe à l'intersection de ces deux axes.

Dans cette représentation, l'angle $\alpha_n$ formé entre la droite $d_n$ et l'horizontale (l'axe $I_0X$) est défini par l'expression suivante :

$$\tan \alpha_n = -\frac{y_n - y_{n-1}}{x_n - x_{n-1}}$$

Comme on le verra plus loin, il est préférable d'adopter la contrainte suivante sur l'angle $\alpha$ (ou $\alpha_n$) :

- $\alpha$ > 10 ° sauf pour n = 1
- et $\alpha_n$ < 80° pour n=N (avec N≥ 2)

Les valeurs des paramètres des profils peuvent être optimisées en fonction de la minimisation recherchée du volume $V_0$.

Ce gain peut être défini par l'expression ci-dessous, en considérant un gain nul lorsque le profil convexe est superposé au profil conique (ou profil standard) :

$$Gain = \frac{\left(V^P{}_0 - V^{Cone}{}_0\right)}{V^{Cone}{}_0}$$

où $V^P{}_0$ et $V^{Cone}{}_0$ représentent, respectivement, le volume $V_0$ pour le cas d'un profil (ici : convexe) P et pour le cas d'un profil plat, équivalent à un cône tronqué.

Sachant que $V^P{}_0 = \pi \int_0^{z0} |f(x)|^2 dx$ avec f (x) étant la fonction du profil P considéré en fonction de la coordonné x, il est alors possible d'estimer le gain en volume pour un profil donné comparativement à celui d'un profil plat.

Pour les profils convexes R1 et R2 déjà mentionnés et illustrés sur la figure 6, le gain est voisin de 30 % ce qui représente une valeur significative.

On a représenté de manière détaillée, sur la figure 3, une portion de la zone cylindrique 12, du conduit 18 alimentation en gaz, et la section convexe 14 qui les relie, entre un point A, située dans la partie supérieure du conduit 18, le point B, qui correspond à l'intersection entre la partie inférieure de la zone cylindrique 12 et le profil convexe 14.

On définit, dans un plan vertical, qui contient l'axe yy' d'injection des gaz, les angles suivants, qui vont permettre de caractériser un peu plus des profils convexes, ou majoritairement convexe, particulièrement adaptés dans le cadre de la présente invention :

- $\theta_1$ est l'angle formé entre :

  * un axe horizontal qui passe par un point B de la section d'extrémité basse de la portion cylindrique 12 ;
  * et la tangente au point d'inflexion I du profil convexe, ou majoritairement convexe, dans le cas où un tel profil présente au moins un point une dérivée seconde nulle ;

- $\theta_2$ est l'angle formé entre :

  * l'axe horizontal qui vient d'être défini
  * et la tangente au profil convexe, au point B ;

- $\theta_3$ est l'angle formé entre le même axe horizontal et un profil conique au point A (point situé sur le pourtour de sortie du conduit 18 d'injection des gaz); ce profil conique est représenté en traits interrompus sur la figure 3 et relie le point A au point B ;
- $\beta$ est l'angle formé entre l'axe vertical YY' et la tangente au profil convexe, au point A.

En ce qui concerne les cotes, on a, sur cette figure :

- le rayon $r_1$ qui est le rayon de l'injection de la conduite d'injection de gaz ;
- le rayon $r_2$, rayon du lit fluidisé dans la partie cylindrique 12 du réacteur à jet ; il correspond sensiblement au rayon de la partie cylindrique, dans un plan perpendiculaire à l'axe YY' ;
- la hauteur $h_1$, ou hauteur de transition entre la cote de l'injection de gaz (cote $Z_0$), et celle à partir de laquelle la section du lit est constante selon l'axe vertical (cote $Z_1$).

Le profil convexe, ou majoritairement convexe, du réacteur est de préférence choisi de la manière suivante, qui favorise la fluidisation de la charge solide.

En particulier, l'apparition d'une voute ou d'une arche de matière solide peut être difficile à rompre si le profil retenu est trop convexe, notamment si la valeur de l'angle $\beta$ (angle entre la verticale et la tangente au profil du réacteur) est trop faible.

Les figures 4A et 4B sont des comparaisons, pour une même charge granulaire (en termes de masse et de caractéristiques physique : poudre monomodale avec une densité d=500 $\mu$m et une masse volumique p=5,9 g/cm$^3$), de l'évolution de la perte de charge à travers :

- un lit à profil linéaire connu (figure 4A), conique, avec $\theta_3$ = 60° ;
- et un lit avec une section d'injection à profil convexe avec un angle $\beta$ =0 (figure 4B).

La figure 4C représente l'évolution de la perte de charge à travers un lit avec une section d'injection à profil convexe, pour une valeur d'angle $\beta$ = 10°, pour une poudre ayant les mêmes caractéristiques que ci-dessus.

Sur ces 3 diagrammes, les triangles noirs correspondent au cas d'un débit croissant, et les croix au cas d'un débit décroissant.

Dans le cas d'un profil conique (figure 4A) on distingue successivement un régime $I_1$, dit « de lit fixe »), un régime $II_1$, pour lequel la partie basse du lit est en mouvement, un régime $III_1$ dit de fontaine irrégulière, suivi par un régime $IV_1$ de fontaine régulière.

Dans le cas d'un profil convexe, avec $\beta$ = 0 (cas d'un profil tangent à la verticale), on a successivement un régime $I_2$, dit « de lit fixe », un régime $II_2$, pour lequel la partie basse du lit est en mouvement, un régime $III_2$ de remous en surface, un régime $IV_2$ de percements irréguliers, et un régime $V_2$ dit de fontaine irrégulière et turbulente. On a pu montrer que, pour une charge dense (pour d> 6) et de granulométrie proche de 500 $\mu$m, la fluidisation est difficile, ce que l'on voit sur la figure 4B. Ceci peut, en particulier, se traduire par une augmentation importante (jusqu'à plus de 100 mbar pour une hauteur de lit voisine de 70 mm) de la perte de charge en fonction de l'augmentation du débit de gaz injecté (c'est le régime $I_2$, dit « de lit fixe ») comparativement à ce que l'on peut constater avec un profil plus évasé ou même conique (cas de la figure 4A).

Par ailleurs, la fontaine générée par l'injection de gaz, dans le cas d'un profil convexe, est plus instable. Il existe une valeur minimale de $\beta$ pour obtenir une fluidisation jugée satisfaisante, en régime stable.

On a représenté, en figure 4C, l'évolution de la perte de charge à travers un lit avec une section d'injection à profil convexe, pour une valeur d'angle $\beta = 10°$. On voit que, en fonction du débit, la perte dé charge est relativement régulière, que le débit soit croissant ou décroissant. Par ailleurs, la perte de charge équivalente, dans le régime $I_3$ dit de lit fixe, est bien moindre que pour le cas où $\beta = 0°$, ce qui dénote un meilleur comportement à la fluidisation dans le cas de ce profil $\beta = 10°$, d'où la préconisation d'avoir un ange $\beta$ au moins égal à 10°.

On a indiqué, sur ce diagramme, successivement, la région $II_3$ du premier percement du lit, la zone $III_3$ d'apparition de remous en surface, une région $IV_3$ de percement irrégulier, l'apparition $V_3$ de bulles en surface, puis la formation, en $VI_3$, d'un régime dit « de fontaine ».

Dee préférence, on choisit, pour les paramètres $\theta_1$, $\theta_2$, $\beta$, $r_1$, $r_2$ d'un profilé convexe les valeurs suivantes :

- $\beta$ : compris entre 5° et 45°, de préférence encore entre 10° et 35° ;
- et/ou $\theta_1$ supérieur à l'angle d'écoulement spontané de la poudre constitutive du lit à fluidiser sur plan incliné (ce qui décrit la capacité d'une poudre à s'écouler naturellement ; pour cela, on forme un tas de cette poudre sur une surface plane initialement horizontale, puis on fait varier, progressivement, l'inclinaison de cette surface plane selon un angle de plus en plus grand : l'angle d'écoulement spontané est celui pour lequel la poudre va s'écouler naturellement); par exemple $\theta_1 \geq 10°$ ;
- et/ou $\theta_2$ supérieur à l'angle d'écoulement spontané de la poudre constitutive du lit à fluidiser ; $\theta_2 \leq 90°$ ;
- et/ou $r_1$ : 5 D (où D est le diamètre des particules à fluidiser) $\leq r_1 \leq r_2/5$;
- et/ou $h_i$ : $> r_2/10$

Un exemple de profil convexe réalisé est représenté sur les figures 7A et 7B.

On voit que, dans cet exemple :

- $h_1 = 68{,}2$ mm ;
- $d_2 = 2xr_2 = 70$ mm.

En outre, on a représenté, en figure 7B, diverses cotes du profil convexe, c'est-à-dire l'écart, pour diverses positions verticales, de la surface de ce profil par rapport à l'axe YY'.

Ainsi on voit que, si on prend l'origine 0 au niveau de la sortie du conduit d'injection des gaz, l'écart, par rapport à l'axe YY', varie de quelque millimètre jusqu'à environ 20 mm, entre une position voisine de la sortie du conduit 18 d'injection des gaz et une position située à environ 60 mm de cette sortie.

On a également représenté, en figure 7A, les moyens, ici des trous taraudées 30, 30', qui permettront de venir fixer la section cylindrique 12 sur la base 140 dans laquelle le profil 14 convexe a été réalisé.

Ce profil a pu être usiné en GCAO, qui permet d'utiliser une équation au cours d'un usinage.

Il a en outre pu être testé.

Il s'agit, en fait, du profil correspondant à l'équation R2, de degré 3, telle que déjà défini ci-dessus.

Un exemple d'application concerne la fabrication de particules de combustibles multicouches utilisés dans un réacteur nucléaire de type HTR. Ce type de réacteur fonctionne à haute température, avec un caloporteur gazeux tel que de l'hélium, le modérateur étant le graphite constitutif du combustible.

Pour la fabrication de particules TRISO constitutives du combustible nucléaire, on met en oeuvre un dispositif réacteur tel qu'il a été décrit ci-dessus (avec les paramètres géométriques de l'exemple donné précédemment en figures 7A et 7B).

On réalise des dépôts, successifs, de pyrocarbone (PyC interne), puis de SiC, puis de nouveau de pyrocarbone (PyC externe) sur des particules (dites noyau) de $UO_2$ de, par exemple, 500 $\mu$m de diamètre.

Les dépôts sont alors successivement réalisés à partir d'acétylène et d'éthylène (pour les dépôts de type pyrocarbone) et de méthyltrichlorosilane (pour le dépôt de SiC).

Le débit de gaz est de l'ordre de 10 Nl/min pour tous les gaz, le gaz porteur du gaz précurseur (la source de pyrocarbone ou de SiC) étant de l'argon.

La température de fonctionnement du réacteur CVD est comprise entre 1200 et 1600°C, selon la nature du dépôt à réaliser.

## Revendications

**1.** Réacteur à lit à jet, comportant une zone cylindrique (12), un conduit (18) d'injection de gaz à la base de la zone cylindrique, et une zone de transition, reliant l'extrémité supérieure du conduit (18) à la base de la zone cylindrique (12), cette zone de transition ayant un profil convexe, ou majoritairement convexe, dans un plan passant par l'axe (YY') d'écoulement d'un fluide dans le conduit (18).

2. Réacteur à lit à jet selon la revendication 1, dont l'angle $\beta$ entre l'axe (YY') d'écoulement d'un fluide dans le conduit (18) et la tangente au profil convexe, ou majoritairement convexe, au point où celui-ci rejoint le conduit (18) est au moins égal à 5°, et, de préférence, inférieur à 45°.

3. Réacteur à lit à jet selon la revendication précédente, l'angle $\beta$ étant au moins égal à 10°, et, de préférence, inférieur à 35°.

4. Réacteur à lit à jet selon l'une des revendications 1 à 3, le profil convexe ou majoritairement convexe présentant un point d'inflexion, et l'angle $\theta_1$ entre, d'une part, un axe perpendiculaire à la direction d'écoulement d'un fluide et passant par la base de la partie cylindrique (12) et, d'autre part, la tangente au point d'inflexion I du profil convexe, étant supérieur à 10°.

5. Réacteur à lit à jet selon l'une des revendications 1 à 4, dans lequel l'angle $\theta_2$ entre, d'une part, un axe perpendiculaire à la direction d'écoulement d'un fluide et passant par la base de la partie cylindrique (12) et, d'autre part, une droite passant par l'extrémité du conduit (18) d'injection de gaz et par la base de la partie cylindrique (12), est inférieur à 90°.

6. Réacteur à lit à jet selon l'une des revendications 1 à 5, dans lequel la distance (h1) entre l'extrémité du conduit (18) d'injection des gaz et la base de la section cylindrique (12) du réacteur est supérieure à 1/10 du rayon ($r_2$) du lit dans cette section cylindrique.

7. Réacteur à lit à jet selon l'une des revendications 1 à 6, dans lequel le profil convexe ou majoritairement convexe, est défini par une succession de N ($N \geq 2$) segments de droite ($d_n$).

8. Procédé de dépôt sur des particules, comportant :

   - l'introduction desdites particules dans un réacteur à lit à jet selon l'une des revendications précédentes,
   - l'introduction, par le conduit (18) d'injection de gaz, d'un gaz transportant un précurseur du dépôt à réaliser sur lesdites particules.

9. Procédé selon la revendication 8, dans lequel $r_1$, rayon du conduit d'injection, est compris entre 5 D (D= diamètre des particules) et 1/5 $r_2$, où $r_2$ est le rayon du lit dans la section cylindrique.

10. Procédé selon la revendication 8 ou 9, le profil convexe présentant un point d'inflexion, et l'angle $\theta_1$ entre, d'une part, un axe perpendiculaire à la direction d'écoulement d'un fluide et passant par la base de la partie cylindrique (12) et, d'autre part, la tangente au point d'inflexion I du profil convexe, ou majoritairement convexe, étant supérieur à l'angle d'écoulement spontané de la poudré constitutive du lit à brasser sur plan incliné.

11. Procédé selon l'une des revendications 8 à 10, l'angle $\theta_2$ entre, d'une part, un axe perpendiculaire à la direction d'écoulement d'un fluide et passant par la base de la partie cylindrique (12) et, d'autre part, une droite passant par l'extrémité du conduit (18) d'injection de gaz et par la base de la partie cylindrique (12), étant supérieur à l'angle d'écoulement spontané de la poudre constitutive du lit à brasser sur plan incliné.

12. Procédé selon l'une des revendications 8 à 11, au moins une partie des particules ayant un diamètre de l'ordre de 500 $\mu$m et/ou la différence de masse volumique entre le gaz de fluidisation et la poudre à fluidiser étant supérieure ou égale à 5 g/$cm^3$.

13. Procédé selon l'une des revendications 8 à 12, dans lequel on réalise une pluralité de dépôts successifs sur lesdites particules.

14. Procédé selon l'une des revendications 8 à 12, les particules étant des particules de combustible utilisé dans les réacteurs nucléaires de type HTR.

## Patentansprüche

1. Wirbelbettreaktor mit einem zylindrischen Bereich (12), einer Leitung (18) zum Einspritzen von Gas an der Basis des zylindrischen Bereichs und mit einem Übergangsbereich, der das obere Ende der Leitung (18) mit der Basis des zylindrischen Bereichs (12) verbindet, wobei dieser Übergangsbereich ein konvexes bzw. überwiegend konvexes Profil in einer Ebene hat, die durch die Strömungsachse (YY') eines Mediums in der Leitung (18) verläuft.

2. Wirbelbettreaktor nach Anspruch 1, wobei der Winkel $\beta$ zwischen der Strömungsachse (YY') eines Mediums in der Leitung (18) und der Tangente zum konvexen bzw. überwiegend konvexen Profil an dem Punkt, wo dieses auf die Leitung (18) trifft, zumindest gleich 5° und vorzugsweise kleiner als 45° ist.

3. Wirbelbettreaktor nach dem vorangehenden Anspruch, wobei der Winkel $\beta$ zumindest gleich 10° und vorzugsweise kleiner als 35° ist.

4. Wirbelbettreaktor nach einem der Ansprüche 1 bis 3, wobei das konvexe bzw. überwiegend konvexe Profil einen Wendepunkt aufweist und der Winkel $\theta_1$ zwischen einer senkrecht zur Strömungsrichtung eines Mediums verlaufenden und durch die Basis des zylindrischen Teils (12) sich erstreckenden Achse einerseits und der Tangente am Wendepunkt I des konvexen Profils andererseits größer als 10° ist.

5. Wirbelbettreaktor nach einem der Ansprüche 1 bis 4, wobei der Winkel $\theta_2$ zwischen einer senkrecht zur Strömungsrichtung eines Mediums verlaufenden und durch die Basis des zylindrischen Teils (12) sich erstreckenden Achse einerseits und einer Geraden durch das Ende der Gaseinspritzleitung (18) und durch die Basis der zylindrischen Teils (12) andererseits kleiner als 90° ist.

6. Wirbelbettreaktor nach einem der Ansprüche 1 bis 5, wobei der Abstand (h1) zwischen dem Ende der Gaseinspritzleitung (18) und der Basis des zylindrischen Abschnitts (12) des Reaktors größer als 1/10 des Radius ($r_2$) des Betts in diesem zylindrischen Abschnitt ist.

7. Wirbelbettreaktor nach einem der Ansprüche 1 bis 6, wobei das konvexe bzw. überwiegend konvexe Profil durch eine Folge von N ($N \geq 2$) Segmenten der Geraden ($d_n$) definiert ist.

8. Verfahren zum Abscheiden auf Partikel, umfassend:

   - das Einführen der Partikel in einen Wirbelbettreaktor nach einem der vorangehenden Ansprüche,
   - das Einführen eines Gases, das einen Vorläufer der durchzuführenden Abscheidung auf die Partikel fördert, über die Gaseinspritzleitung (18).

9. Verfahren nach Anspruch 8, wobei $r_1$, Radius der Einspritzleitung, zwischen 5 D (D = Durchmesser der Partikel) und 1/5 $r_2$ ist, wobei $r_2$ der Radius des Betts im zylindrischen Abschnitt ist.

10. Verfahren nach Anspruch 8 oder 9, wobei das konvexe Profil einen Wendpunkt aufweist und der Winkel $\theta_1$ zwischen einer senkrecht zur Strömungsrichtung eines Mediums verlaufenden und durch die Basis des zylindrischen Teils (12) sich erstreckenden Achse einerseits und der Tangente am Wendpunkt I des konvexen bzw. überwiegend konvexen Profils andererseits größer ist als der spontane Strömungswinkel des Pulvers, das das auf geneigter Ebene zu durchmischende Bett bildet.

11. Verfahren nach einem der Ansprüche 8 bis 10, wobei der Winkel $\theta_1$ zwischen einer senkrecht zur Strömungsrichtung eines Mediums verlaufenden und durch die Basis des zylindrischen Teils (12) sich erstreckenden Achse einerseits und einer durch das Ende der Gaseinspritzleitung (18) und die Basis des zylindrischen Teils (12) verlaufenden Gerade andererseits größer als der spontane Strömungswinkel des Pulvers ist, das das auf geneigter Ebene zu durchmischende Bett bildet.

12. Verfahren nach einem der Ansprüche 8 bis 11, wobei zumindest ein Teil der Partikel einen Durchmesser in der Größenordnung von 500 $\mu$m hat und/oder der Dichteunterschied zwischen dem Fluidisierungsgas und dem zu fluidisierenden Pulver größer oder gleich 5 g/$cm^3$ ist.

13. Verfahren nach einem der Ansprüche 8 bis 12, wobei eine Mehrzahl von aufeinanderfolgenden Abscheidungen auf die Partikel erfolgt.

**14.** Verfahren nach einem der Ansprüche 8 bis 12, wobei die Partikel BrennstoffPartikel sind, die bei Kernreaktoren vom Typ HTR verwendet werden.

## Claims

**1.** Jet spouted bed reactor, comprising a cylindrical area (12), a gas injection pipe (18) at the base of the cylindrical area, and a transition area, connecting the upper end of the pipe (18) to the base of the cylindrical area (12), this transition area having a convex, or predominantly convex, profile in a plane extending through the axis (YY') of flow of a fluid in the pipe (18).

**2.** Jet spouted bed reactor according to claim 1, in which the angle between the axis (YY') of flow of a fluid in the pipe (18) and the tangent to the convex, or predominantly convex, profile at the point where it joins the pipe (18) is at least equal to 5°, and, preferably, less than 45°.

**3.** Jet spouted bed reactor according to the preceding claim, the angle $\beta$ being at least equal to 10°, and, preferably, less than 35°.

**4.** Jet spouted bed reactor according to one of claims 1 to 3, the convex or predominantly convex profile having a point of inflexion, and the angle $\theta_1$ between, on the one hand, an axis perpendicular to the direction of flow of a fluid and extending through the base of the cylindrical part (12) and, on the other hand, the tangent to the point of inflexion I of the convex profile, being greater than 10°.

**5.** Jet spouted bed reactor according to one of claims 1 to 4, wherein the angle $\theta_2$ between, on the one hand, an axis perpendicular to the direction of flow of a fluid and extending through the base of the cylindrical part (12) and, on the other hand, a straight line extending through the end of the gas injection pipe (18) and through the base of the cylindrical part (12), is less than 90°.

**6.** Jet spouted bed reactor according to one of claims 1 to 5, wherein the distance (h1) between the end of the gas injection pipe (18) and the base of the cylindrical section (12) of the reactor is greater than 1/10 of the radius ($r_2$) of the bed in this cylindrical section.

**7.** Jet spouted bed reactor according to one of claims 1 to 6, wherein the convex or predominantly convex profile is defined by a succession of N ($N \geq 2$) straight line segments ($d_n$).

**8.** Method of deposition on particles, comprising:

- the introduction of said particles into a jet spouted bed reactor according to one of the preceding claims,
- the introduction, via the gas injection pipe (18), of a gas transporting a precursor of the deposition to be carried out on said particles.

**9.** Method according to claim 8, wherein $r_1$, the radius of the injection pipe, is comprised between 5 D (D = diameter of the particles) and 1/5 $r_2$, where $r_2$ is the radius of the bed in the cylindrical section.

**10.** Method according to claim 8 or 9, the convex profile having a point of inflexion, and the angle $\theta_1$ between, on the one hand, an axis perpendicular to the direction of flow of a fluid and extending through the base of the cylindrical part (12) and, on the other hand, the tangent to the point of inflexion I of the convex, or predominantly convex, profile being greater than the angle of spontaneous flow of the powder constituting the bed to be fluidised on an inclined plane.

**11.** Method according to one of claims 8 to 10, the angle $\theta_2$ between, on the one hand, an axis perpendicular to the direction of flow of a fluid and extending through the base of the cylindrical part (12) and, on the other hand, a straight line extending through the end of the gas injection pipe (18) and through the base of the cylindrical part (12), being greater than the angle of spontaneous flow of the powder constituting the bed to be fluidised on an inclined plane.

**12.** Method according to one of claims 8 to 11, at least a part of the particles having a diameter of the order of 500 $\mu m$ and/or the difference in specific mass between the fluidisation gas and the powder to be fluidised being greater than or equal to 5 $g/cm^3$.

**13.** Method according to one of claims 8 to 12, wherein a plurality of successive depositions are carried out on said particles.

**14.** Method according to one of claims 8 to 12, the particles being fuel particles used in HTR type nuclear reactors.

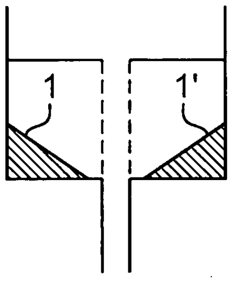


FIG.1A

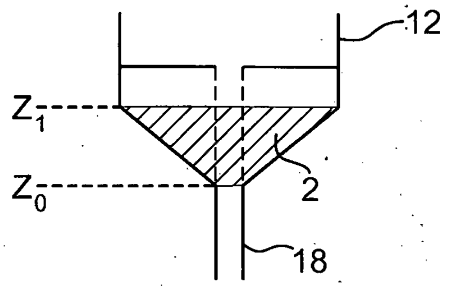


FIG.1B

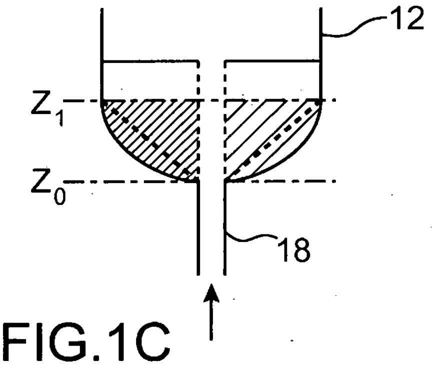


FIG.1C

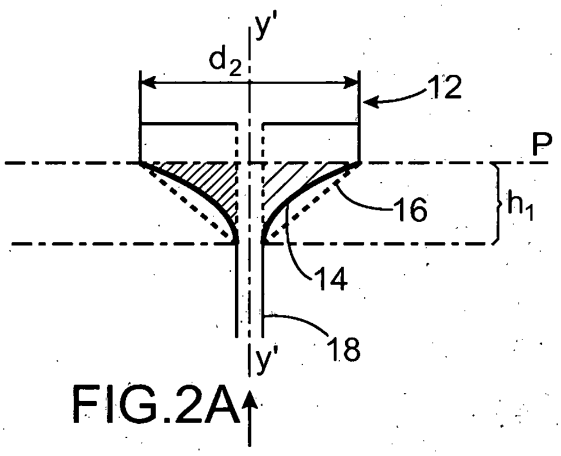


FIG.2A

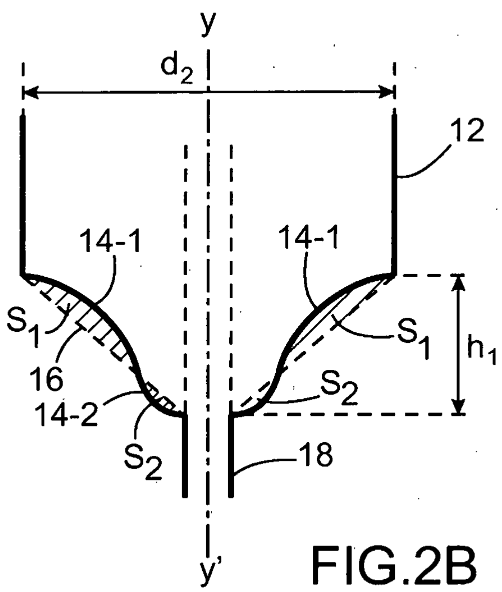


FIG.2B

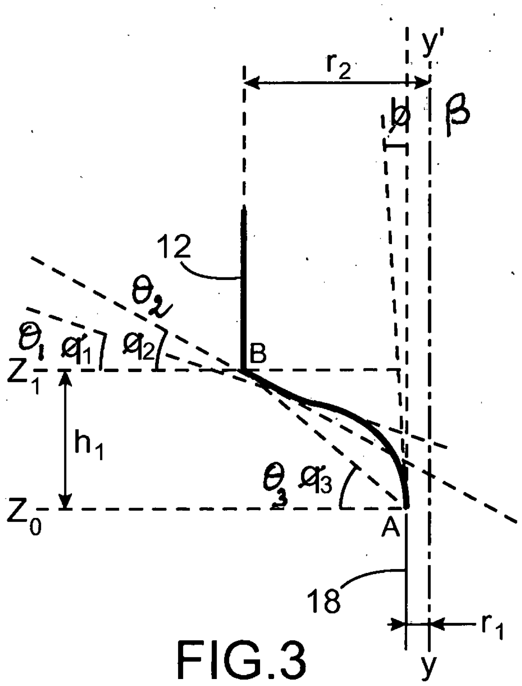


FIG.3

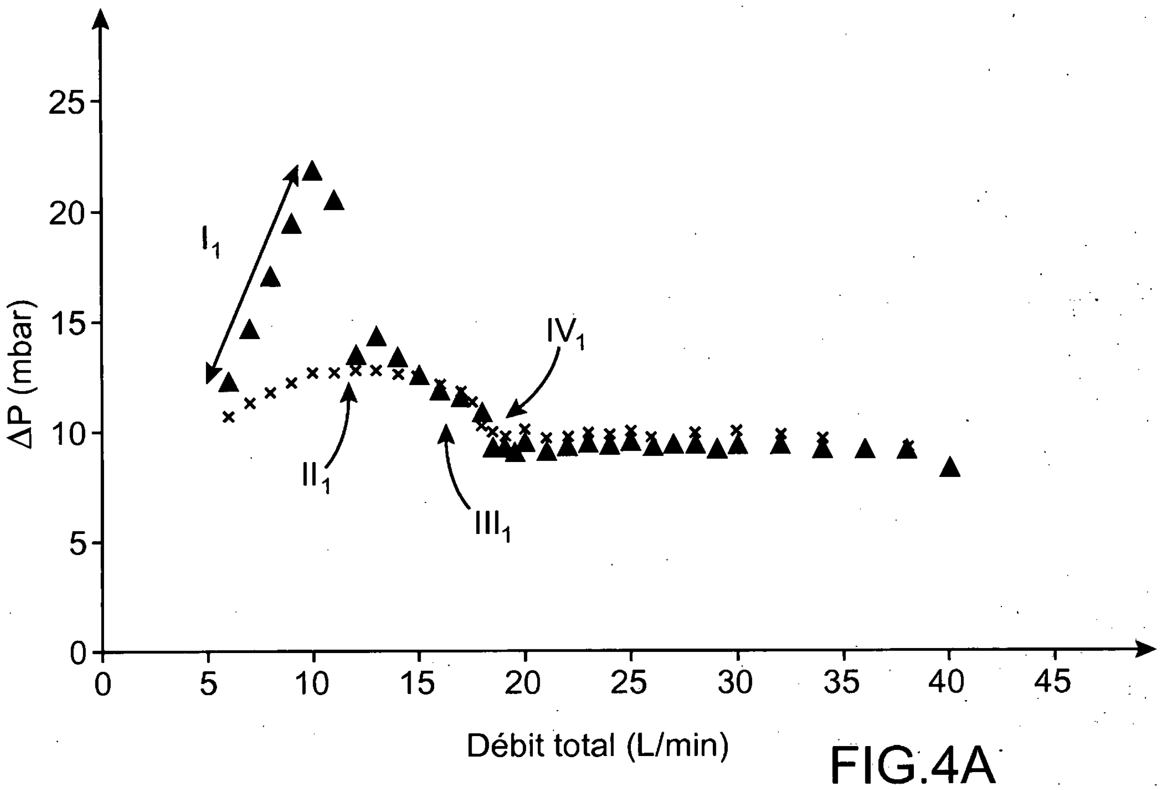
25
20
15
10
5
0
ΔP (mbar)
0
5
10
15
20
25
30
35
40
45
Débit total (L/min)
I1
II1
III1
IV1

FIG.4A

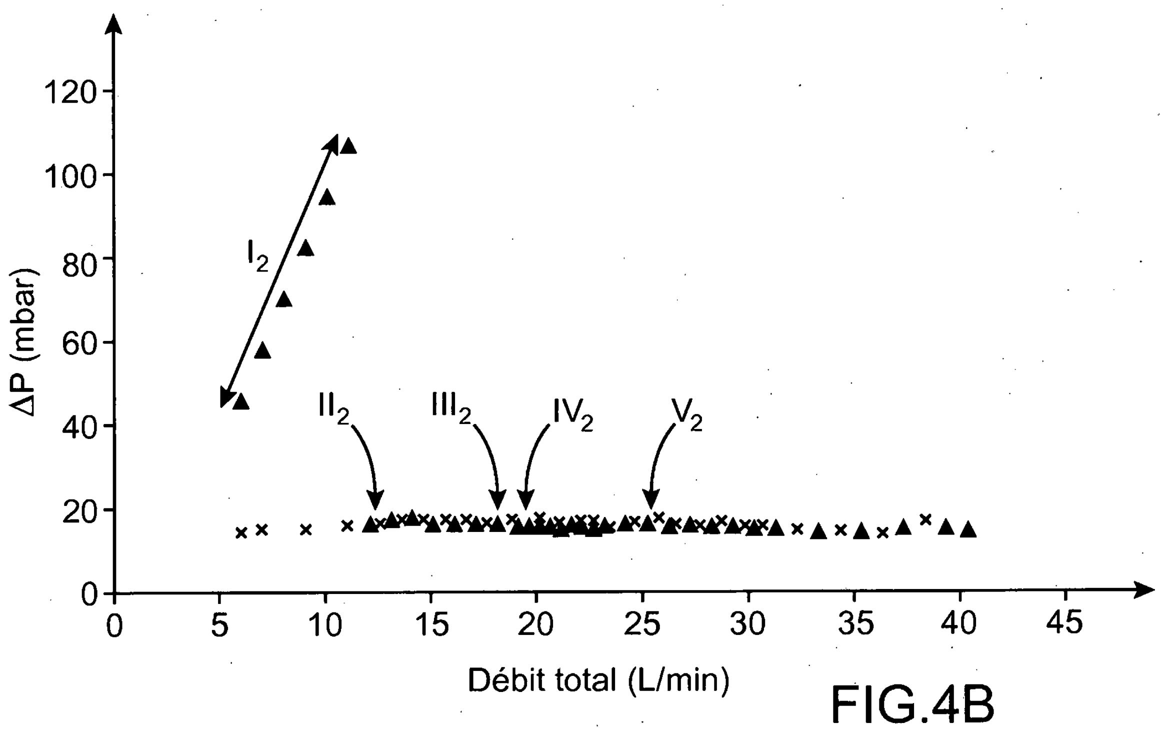
120
100
80
60
40
20
0
ΔP (mbar)
0
5
10
15
20
25
30
35
40
45
Débit total (L/min)
I2
II2
III2
IV2
V2

FIG.4B

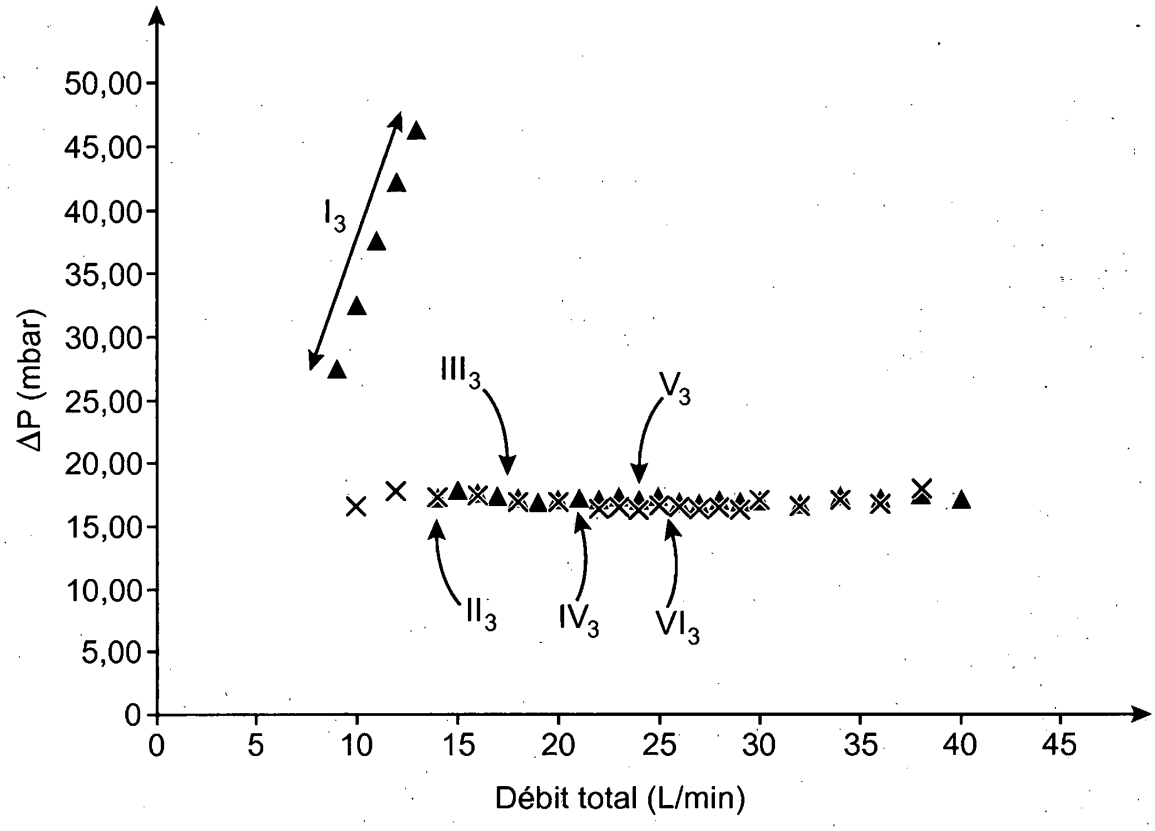

50,00
45,00
40,00
35,00
30,00
25,00
20,00
15,00
10,00
5,00
0
ΔP (mbar)
0
5
10
15
20
25
30
35
40
45
Débit total (L/min)
$I_3$
$III_3$
$V_3$
$II_3$
$IV_3$
$VI_3$


FIG.4C

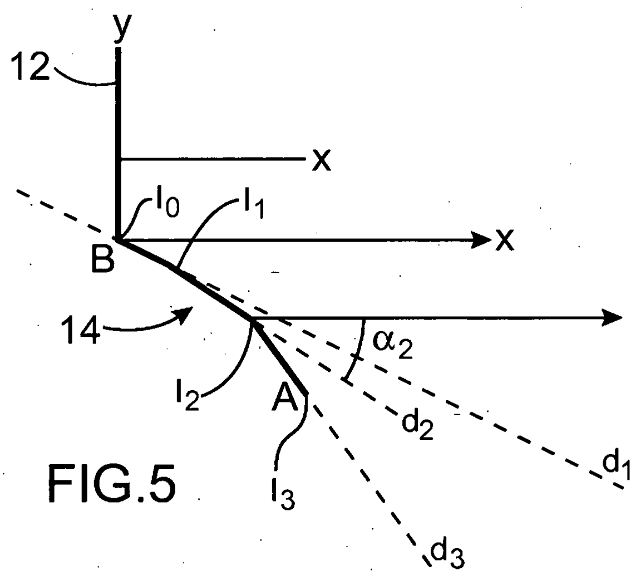

y
12
x
$I_0$
$I_1$
B
x
14
$\alpha_2$
$I_2$
A
$d_2$
$d_1$
$I_3$
$d_3$


FIG.5

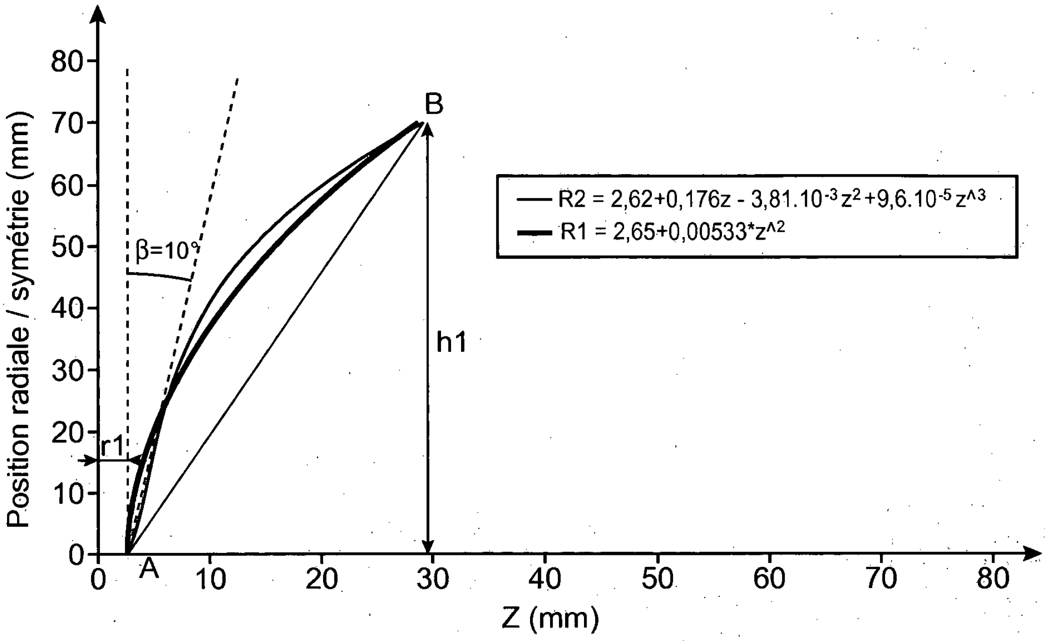
Position radiale / symétrie (mm)
80
70
60
50
40
30
20
10
0
0
10
20
30
40
50
60
70
80
Z (mm)
B
A
h1
r1
β=10°
R2 = 2,62+0,176z - 3,81.10-3 z2 +9,6.10-5 z^3
R1 = 2,65+0,00533*z^2

FIG.6

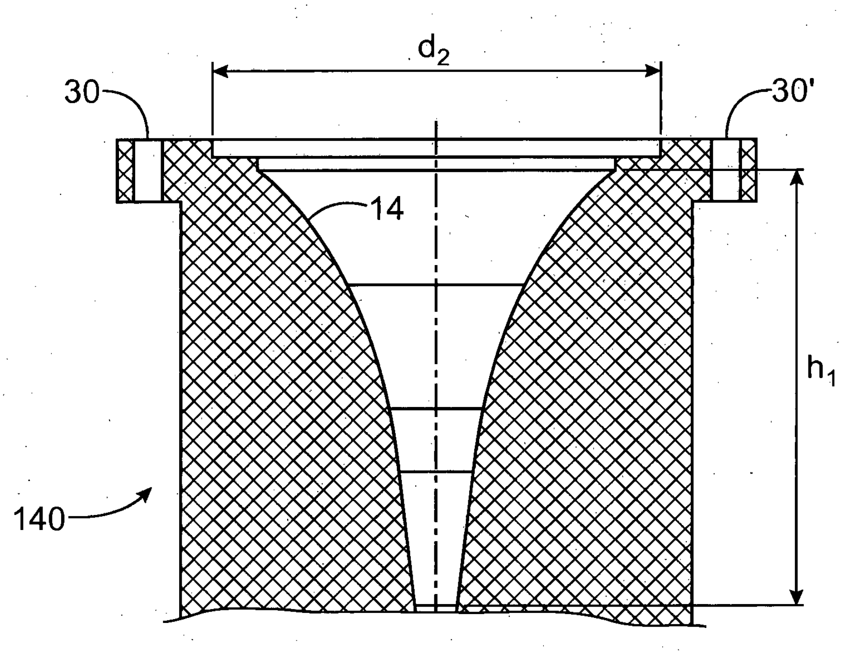
d2
30
30'
14
h1
140

FIG.7A

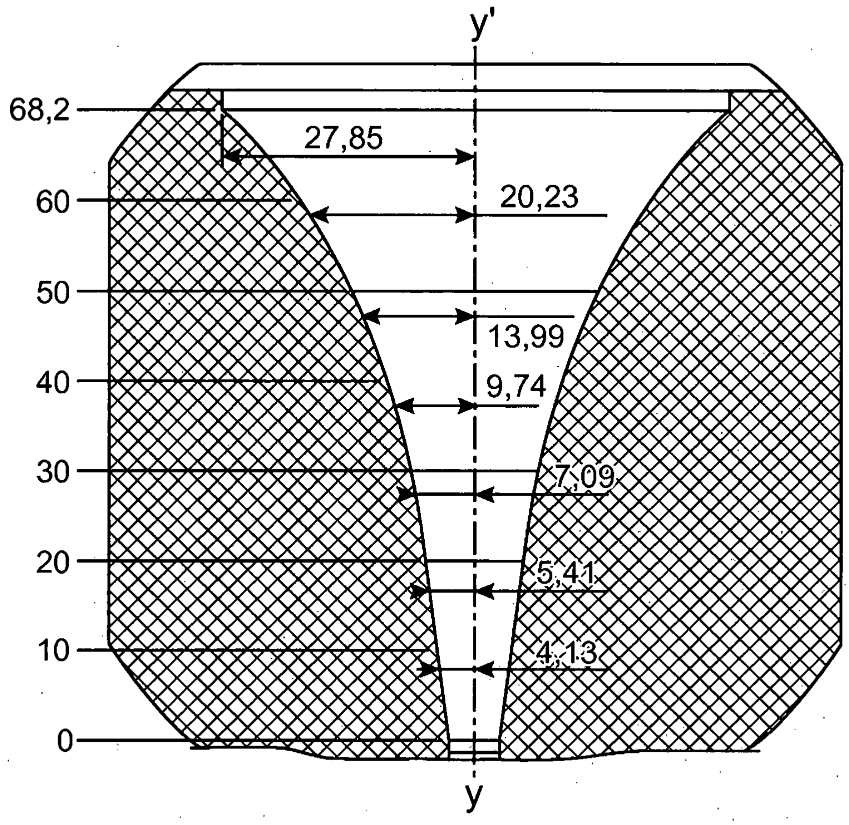
y'
68,2
27,85
60
20,23
50
13,99
40
9,74
30
7,09
20
5,41
10
4,13
0
y

FIG.7B

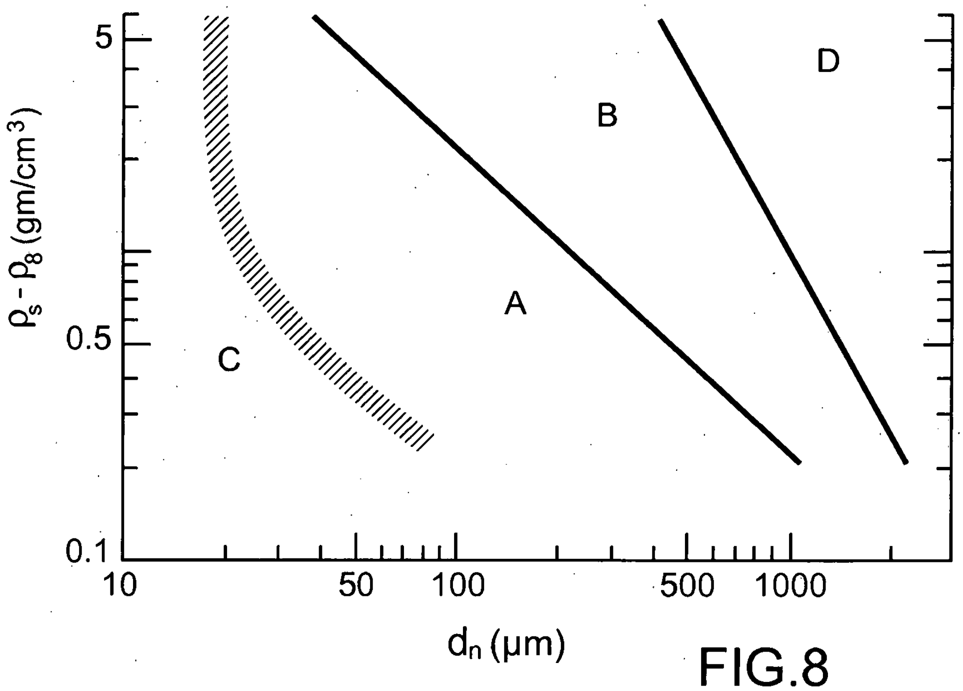
5
0.5
0.1
$\rho_s - \rho_8$ (gm/cm$^3$)
10
50
100
500
1000
$d_n$ (µm)
A
B
C
D

FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- DE 437970
- CA 601607
- US 4342284 A
- GB 1567256 A
- EP 1752991 A
- EP 1550502 A
- CN 101830627
- US 20090149620 A
- RU 2377487


### Littérature non-brevet citée dans la description


- **MATHUR, K. B. ; GISHLER, P. E.** *A.1.Ch.E. J.,* 1955, vol. 1, 157
- **GELDART D.** *Powder Technology,* 1973, vol. 7, 285